# EUROPÄISCHE PATENTSCHRIFT

(11) **EP 2 092 813 B1**
(45) Veröffentlichungstag und Bekanntmachung des Hinweises auf die Patenterteilung: **14.12.2011**
(21) Anmeldenummer: 07847346.9
(22) Anmeldetag: 26.11.2007
(51) Int. Cl.: H05K 3/34, H01R 4/48

(54) **ELEKTRISCHE LEITERPLATTE MIT EINER ANSCHLUSSKLEMME**
ELECTRICAL PRINTED CIRCUIT BOARD COMPRISING A TERMINAL CONNECTION
CARTE ÉLECTRIQUE DE CIRCUITS IMPRIMÉS COMPRENANT UNE BORNE DE CONNEXION

(30) Priorität: 27.11.2006 DE 102006056259
(43) Veröffentlichungstag der Anmeldung: 26.08.2009
(73) Patentinhaber: Kostal Industrie Elektrik GmbH, 58513 Lüdenscheid (DE)
(72) Erfinder: RÜGGEN, Christian, 44805 Bochum (DE); RILLING, Herwig, 59174 Kamen (DE)
(74) Vertreter: Kerkmann, Detlef
(86) Internationale Anmeldenummer: PCT/EP2007/062813
(87) Internationale Veröffentlichungsnummer: WO 2008/065076

(56) Entgegenhaltungen:
- DE-A1- 3 817 706
- DE-A1- 4 324 917
- DE-C1- 10 153 170
- DE-U1- 20 311 184
- US-A- 3 079 578

## Beschreibung

Die Erfindung betrifft eine elektrische Leiterplatte mit einer schraubenlosen Anschlussklemme, welche eine mit Anschlussleiterbahnen der Leiterplatte verlötete Stromschiene sowie eine an der Stromschiene festgelegte Klemmfeder umfasst.

Eine solche Leiterplatte dient zum Verbinden flexibler Leitungen miteinander sowie insbesondere mit elektrischen bzw. elektronischen Bauelementen. Dabei kommt es in erster Linie auf eine sichere elektrische Kontaktierung bei gleichzeitig unkomplizierter Handhabung an.

Eingesetzt werden derartige Leiterplatten beispielsweise in Anschlussdosen für Solarzellenmodule, wobei die Anschlussklemmen dann einerseits die üblicherweise als Flachbänder ausgeführten Anschlussleiter der Solarzellenmodule und andererseits die z.B. zu einem Wechselrichter führenden Ausgangsleitungen kontaktieren.

Die DE 43 24 917 A1 zeigt ein elektrisches Kontaktelement für eine Leiterplatten-Randverbindung mit einem Leiterdraht. Das Kontaktelement besteht dabei als einstückiges Blechstanzteil aus einem Leiterdraht-Anschlussteil und einem Kontaktteil, wobei das Leiterdraht-Anschlussteil als Crimpteil ausgeführt ist.

Die DE 38 17 706 A1 zeigt eine schraubenlose Anschlussklemme, die einteilig ausgeführt und an der Leiterplatte in einer Durchgangsöffnung derselben festgeklemmt ist.

DE 203 11 184 U1 offenbart eine Anschlussdose zum Anschließen an ein Solarpanel, wobei auf einer Leiterplatte Bypass-Dioden vorhanden sind.

Die Leiterplatte gemäß der vorliegenden Erfindung hat gegenüber vorbekannten Leiterplatten den Vorteil, dass sie eine mechanisch sehr robuste und damit auch für raue Einsatzbedingungen geeignete Ausführung bei gleichzeitig geringem Herstellungsaufwand ermöglicht.

Dies wird erfindungsgemäß dadurch erreicht, dass die Leiterplatte an ihrem Rand mit einer Ausnehmung versehen ist, welche von einem Basisbereich der Stromschiene überbrückt wird, und dass die Klemmfeder an dem Basisbereich der Stromschiene mit einem ihrer Federschenkel so zur Anlage kommt, dass der andere Federschenkel sich durch die Ausnehmung hindurch auf der Unterseite der Leiterplatte erstreckt.

Der robuste Aufbau ermöglicht es zudem, dass die Stromschiene auch als Gegenlager zum Aufhebeln der Federklemme mit einem Hebelwerkzeug wie z.B. einem Schraubendreher oder einem speziell angefertigten Werkzeug mit dem auch mehrere nebeneinander befindliche Klemmen gleichzeitig geöffnet werden können, dienen kann. Damit kann auf fest mit den jeweiligen Klemmen verbundene Handhabungseinrichtungen verzichtet werden.

Wenn die Federklemme geöffnet ist, können hierin Solaranschlussleitungen mit großen Leitungsquerschnitten und ebenso im Solarbereich übliche flache Bänder mit erheblicher Breite eingesteckt und nach Entfernen des Hebelwerkzeugs geklemmt werden.

In einer insbesondere für die Verwendung in einer Solaranschlussdose geeigneten Weiterbildung der erfindungsgemäßen Leiterplatte wird durch eine großflächige Kupferkaschierung der Leiterplattenoberfläche eine äußerst wirksame Kühlfläche zur Verfügung gestellt, die in diesem Falle die insbesondere durch die in den Bypass-Dioden der Solaranschlussdose auftretende Verlustleistung entstehende Wärme an die Umgebung abgibt.

Nachfolgend ist die Erfindung anhand eines Ausführungsbeispiels unter Bezugnahme auf die beigefügte Zeichnung erläutert.

Dabei zeigen:
- **Fig. 1:**: einen Abschnitt einer erfindungsgemäßen Leiterplatte im Bereich einer schraubenlosen Anschlussklemme in einer ersten Ausführungsform
- **Fig. 2:**: die Anschlussklemme aus Fig. 1 im Längsschnitt
- **Fig. 3:**: der Leiterplattenbereich aus Fig. 1 im Längsschnitt beim Einführen eines anzuschließenden Leiters in die Anschlussklemme
- **Fig. 4:**: eine Anschlussklemme in einer vorteilhaften zweiten Ausführungsform als Einzelteil mit eingeführtem Anschlussleiter
- **Fig. 5:**: eine erfindungsgemäße Leiterplatte mit mehreren schraubenlosen Anschlussklemmen

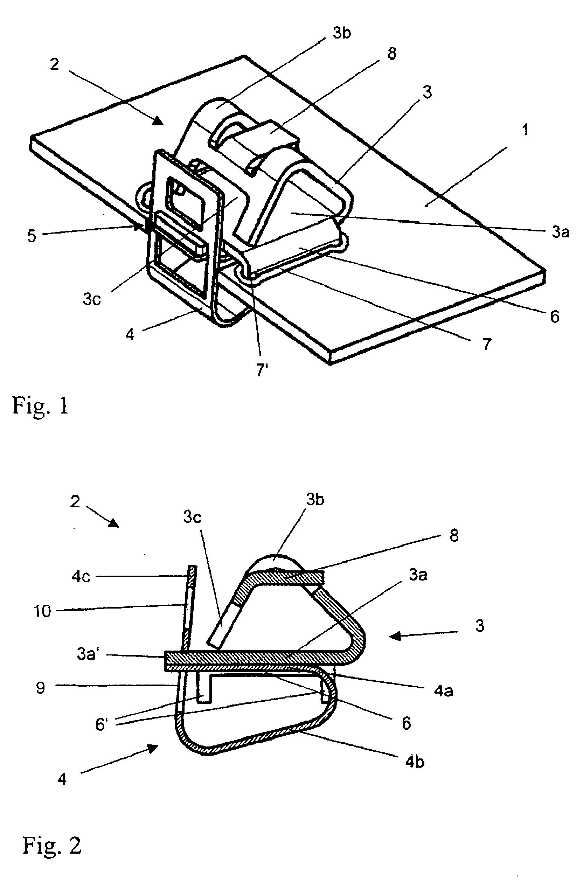

Wie in Fig. 1 zu erkennen, ist die erfindungsgemäße Leiterplatte 1 an der zur Montage der schraubenlosen Anschlussklemme 2 vorgesehenen Position an ihrem Rand mit einer rechteckigen Ausnehmung 5 versehen. Die dort angebrachte Anschlussklemme 2 umfasst dabei eine mit Anschlussleiterbahnen der Leiterplatte 1 verlötete Stromschiene 3 und eine an der Stromschiene 3 festgelegte Klemmfeder 4.

Die Stromschiene 3 ist als Stanz-Biegeteil aus einem Blechmaterial mit einer guten elektrischen Leitfähigkeit gefertigt. Ein Basisbereich 3a der Stromschiene 3 ist parallel zur Oberfläche der Leiterplatte 1 angeordnet und überbrückt mit seiner Fläche die randliche Ausnehmung 5 der Leiterplatte 1. An der rechten und linken Seite des Basisbereichs 3a sind durch Abwinklung des Blechs um 90° auf die Leiterplatte 1 zu weisende Laschen 6 gebildet, die an ihren vorderen und hinteren Enden mit Anschlussbeinchen 6' versehen sind. Seitlich neben der Ausnehmung 5 der Leiterplatte 1 sind durch Teile der Anschlussleiterbahnen der Leiterplatte 1 gebildete großflächige Lötpads 7 angeordnet, die entsprechend positionierte Bohrungen 7' zur Aufnahme der Anschlussbeinchen 6' der Stromschiene 3 aufweisen. Die Anschlussbeinchen 6' tauchen dabei so weit in die Bohrungen ein, dass die Unterkanten der Laschen 6 zwischen diesen auf den Lötpads 7 zur Anlage an der Leiterplatte 1 kommen. Die Lötpads 7 sind vor der Montage der Stromschiene 3 mit einer Reflow-Lötpaste beschichtet, die im Verlauf der Fertigung der Leiterplatte 1 in einem Reflow-Ofen die Lötverbindung zwischen der Stromschiene 3 und den Anschlussleiterbahnen der Leiterplatte 1 bildet. Durch die großflächige Lötverbindung sowie das Durchtauchen der Anschlussbeinchen 6' durch die Bohrungen 7' in der Leiterplatte 1 ist eine sehr stabile mechanische Verbindung gewährleistet, die auch größeren Belastungen standhält.

Wie insbesondere auch in dem Längsschnitt durch die Anschlussklemme 2 in Fig. 2 sehr gut zu erkennen ist, erhält die Stromschiene 3 durch zwei Abwinklungen ihres Blechs in dem an den Basisbereich 3a derselben in deren hinterem, d.h. dem Leiterplattenrand abgewandten Seite anschließenden Bereich um zunächst etwa 135° und anschließend um etwa 90° eine im Längsschnitt annähernd dreieckige Kontur. Das dabei von oben auf die vordere Kante des Basisbereichs 3a zurückgebogene Ende des Blechs ist in der Mitte mit einer Ausnehmung 3c versehen, durch die der durch die Anschlussklemme 2 zu kontaktierende Leiter eingeführt wird. Ein in der Mitte des Blechs im Bereich der oberen Kante 3b des Dreiecks freigeschnittener Streifen ist als eine parallel zum Basisbereich 3a der Stromschiene 3 verlaufende Zunge 8 ausgestellt.

Die Klemmfeder 4 ist ebenfalls als Stanz-Biegeteil aus einem Blechstreifen hergestellt, allerdings aus einem Material mit einer guten elastischen Verformbarkeit, d.h. mit guten Federeigenschaften.

Der Blechstreifen ist dazu mit drei langgestreckten Bereichen versehen, die durch zwei Biegebereiche verbunden sind. Dabei schließt sich an einen ersten Federschenkel 4a über einen annähernd einen Halbkreis beschreibenden Biegebereich ein zweiter Federschenkel 4b an, und an diesen nach einer Biegung um etwa einen Viertelkreis ein dritter Schenkel 4c, der in seiner Fläche mit zwei rechteckigen Öffnungen 9, 10 versehen ist.

Die erste und größere, der Abwinklung am nächsten gelegene der beiden rechteckigen Öffnungen in dem dritten Schenkel 4c der Klemmfeder 4 dient dabei als Klemmöffnung 9, durch die der anzuschließende Leiter in die Anschlussklemme 2 eingeführt wird. Durch die obere Kante 9' der Klemmöffnung 9 wird der Leiter dann klemmend in dieser gehalten. Die zweite rechteckige Öffnung dient als Betätigungsöffnung 10, durch die ein Werkzeug zum Öffnen der Anschlussklemme 2 eingeführt wird.

Der erste Federschenkel 4a der Klemmfeder 4 ist so lang ausgebildet, dass er im Ausgangszustand mit seinem Ende durch die Klemmöffnung 9 in dem dritten Schenkel 4c hindurchtaucht. Die Klemmfeder 4 steht dadurch bereits im Ausgangszustand unter einer gewissen Vorspannung.

Die Klemmfeder 4 ist an der Stromschiene 3 festgelegt, und zwar so, dass die Klemmfeder 4 an dem Basisbereich 3a der Stromschiene 3 an dessen Unterseite mit ihrem ersten Federschenkel 4a flächig zur Anlage kommt. Der zweite Federschenkel 4b erstreckt sich durch die Ausnehmung 5 der Leiterplatte 1 schräg nach unten in Richtung auf den Randbereich der Leiterplatte 1 zu. Der daran anschließende dritte Schenkel 4c der Klemmfeder 4 verläuft annähernd senkrecht zur Leiterplattenoberfläche. Durch eine zwischen der oberen Kante 9' der Klemmöffnung 9 und dem Ende des ersten Federschenkels 4a der Klemmfeder 4 eingeklemmten vorderen Fortsatz 3a' des Basisbereichs 3a der Stromschiene 3 ist die Klemmfeder 4 an der Stromschiene 3 gehalten.

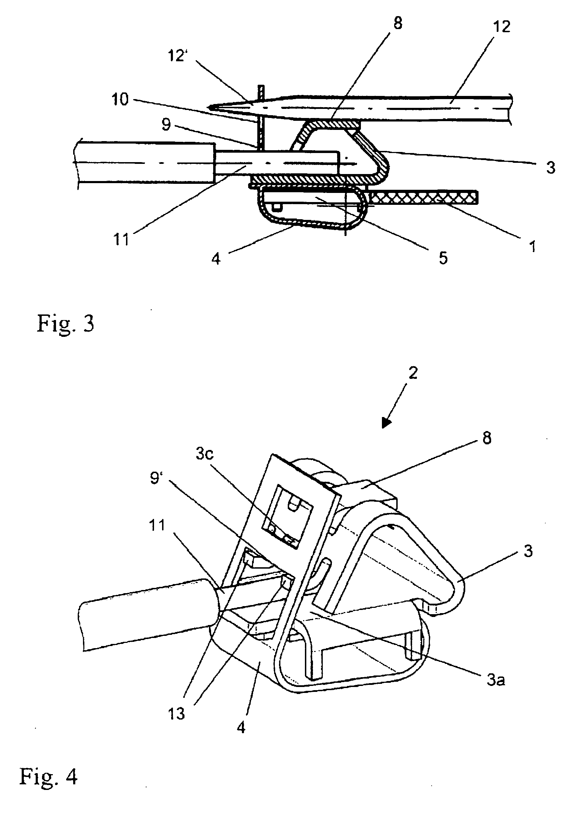

In Fig. 3 ist zu sehen, wie die Anschlussklemme 2 zum Einführen eines Leiters 11 mit einem Werkzeug 12 geöffnet wird. Dabei wird das Werkzeug 12, z.B. ein Schraubendreher mit seiner Klinge 12' von der Rückseite der Anschlussklemme 2 her in die Betätigungsöffnung 10 eingeführt. Mit der in der Mitte des Blechs im Bereich der oberen Kante des Dreiecks verlaufenden Zunge 8 als Widerlager, kann das Werkzeug 12 als Hebel eingesetzt werden, um den dritten Schenkel 4c der Klemmfeder 4 nach oben zu bewegen, so dass die Klemmöffnung 9 zur Aufnahme des anzuschießenden Leiters 11 freigegeben wird. Der Leiter 11 wird, wie in der Zeichnung zu sehen, eingeschoben und nach Entfernen des Werkzeugs 12 durch die über die obere Kante 9' der Klemmöffnung 9 auf diesen ausgeübte Federkraft gegen die Stromschiene 3 gedrückt. Dabei wird der Leiter 11 in dieser Position festgehalten und es wird ein elektrischer Kontakt zur Stromschiene 3 hergestellt.

In Fig. 4 ist eine weitere Ausführung der Anschlussklemme 2 gemäß einer vorteilhaften Weiterbildung gezeigt, deren Aufbau und Funktionsweise grundsätzlich genauso ist, wie zuvor beschrieben. Zusätzlich weist die Stromschiene 3 dieser Anschlussklemme 2 jedoch zwei Aufstellhaken 13 auf, die aus dem von oben auf die vordere Kante des Basisbereichs 3a zurückgebogenen Ende des Blechs beiderseits der Ausnehmung 3c, durch die der durch die Anschlussklemme 2 zu kontaktierende Leiter 11 eingeführt wird, zum Rand der Leiterplatte 1 weisend ausgestellt sind. Sie verlaufen dabei im wesentlichen parallel zum Basisbereich 3a der Stromschiene 3 und sind damit oberhalb und seitlich des Einführbereichs für den zu kontaktierende Leiter 11 angeordnet. Diese Aufstellhaken 13 ermöglichen eine Fixierung der Klemmfeder 4 in der zum Einführen des Leiters 11 geöffneten Stellung, so dass das zuvor beschriebene Öffnen der Anschlussklemme 2 mittels des Werkzeugs 12 bereits in einem vorbereitenden Arbeitsgang vor der eigentlichen Montage der Leiter 11 an der Leiterplatte 1 erfolgen kann, indem die Klemmöffnung 9 mit ihrer oberen Kante 9' nach hinten über die Aufstellhaken 13 gezogen wird. Nach Einführen des Leiters 11 muss dann lediglich die Klemmfeder 4 wieder freigegeben werden, was mit einem leichten Druck nach vorne gegen den oberen Bereich der Klemmfeder 4 erfolgt.

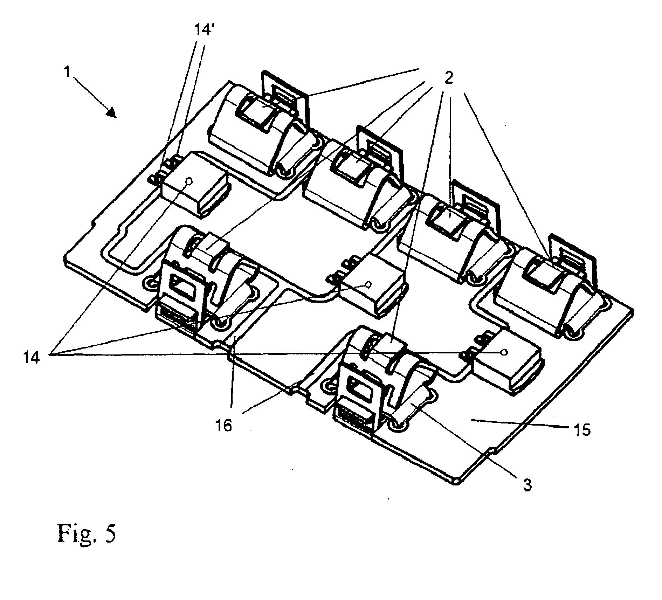

Fig. 5 zeigt eine erfindungsgemäße Leiterplatte 1 mit sechs Anschlussklemmen 2 und drei Halbleiterbauelementen. Es handelt sich hierbei um eine Leiterplatte 1 einer Anschlussbox für Solarzellenmodule. Die Halbleiterbauelemente sind die sogenannten Bypass-Dioden 14, die jeweils parallel zu einem mehrere Solarzellen umfassenden Solarzellenmodul in Sperrrichtung geschaltet sind. Die Bypass-Dioden 14 sind als SMD-Bauelement auf der Leiterplatte 1 montiert und werden bei dem gleichen Reflow-Lötprozess wie die Stromschienen 3 mit der Leiterplatte 1 verlötet. Der eine Anschluss der Bypass-Dioden 14 ist dabei durch die in der Zeichnung sichtbaren Beinchen gebildet der andere Anschluss befindet sich auf der nicht sichtbaren Unterseite der Bauelemente.

Bei einer Abschattung eines oder mehrerer der Solarzellenmodule, d.h. bei einer durch Lichtstrahlenbarrieren - wie z.B. sehr dichte Bewölkung - hervorgerufenen deutlichen lokalen Reduzierung der einfallenden Lichtstrahlen auf einzelne der Solarzellen, wird der Strom der nicht von der Abschattung betroffenen Solarzellenmodule bestimmungsgemäß über die zum Schutz der betroffenen Solarzellenmodule vorgesehenen Bypass-Dioden 14 geleitet. Die dabei entstehende Verlustleistung kann durchaus beachtliche Ausmaße annehmen, was zu einer entsprechenden Wärmeentwicklung führt.

Die Leiterplatte 1 ist auf ihrer Oberseite mit einer annähernd vollflächigen Kupferkaschierung 15 versehen, wobei lediglich schmale Pfade 16 zur Trennung der verschiedenen Potentiale voneinander von der Kupferkaschierung 15 befreit sind. Diese großflächige Kupferkaschierung 15 bildet große wirksame Leiterbahnquerschnitte und gewährleistet damit eine entsprechend hohe Stromtragfähigkeit der jeweiligen Verbindung. Ein weiterer Effekt der großflächigen Kupferkaschierung 15 besteht darin, dass sie über ihre Oberfläche sehr viel Wärme abstrahlen kann und somit gemeinsam mit den Stromschienen 3 als Kühlkörper dient, über den die durch die oben angesprochene Verlustleistung der Bypass-Dioden 14 entwickelte Wärme an die Umgebung abgegeben werden kann.

Zur Ausbildung einer Anschlussbox für Solarzellenmodule ist die Leiterplatte 1 in einem entsprechend gestalteten Gehäuse aufgenommen. Dieses hier nicht gezeigte Gehäuse kann dabei über weitere Elemente zur Erhöhung der mechanischen Stabilität, wie z.B. mehrere Befestigungspunkte für die Leiterplatte 1, Verstärkungsrippen und ähnliches aufweisen. Zur Betätigung der Anschlussklemmen 2 sowie zur Abführung der Verlustwärme ist das Gehäuse mit bedarfsgemäß angepassten Öffnungen versehen.

## Patentansprüche

1. Elektrische Leiterplatte (1) mit einer schraubenlosen Anschlussklemme (2), welche eine mit Anschlussleiterbahnen der Leiterplatte (1) verlötete Stromschiene (3) sowie eine an der Stromschiene (3) festgelegte Klemmfeder (4) umfasst, **dadurch gekennzeichnet, dass** die Leiterplatte (1) an ihrem Rand mit einer Ausnehmung (5) versehen ist, welche von einem Basisbereich (3a) der Stromschiene (3) auf der Oberseite der Leiterplatte (1) überbrückt wird, und dass die Klemmfeder (4) an dem Basisbereich (3a) der Stromschiene (3) mit einem ihrer Federschenkel (4a) so zur Anlage kommt, dass ein anderer Federschenkel (4b) sich durch die Ausnehmung (5) hindurch auf der Unterseite der Leiterplatte (1) erstreckt.

2. Elektrische Leiterplatte (1) nach Anspruch 1, **dadurch gekennzeichnet, dass** die Stromschiene (3) mit Anschlussbeinchen (6') versehen ist, die in zugeordnete Bohrungen (7') auf der Leiterplatte (1) eintauchen.

3. Elektrische Leiterplatte (1) nach Anspruch 1oder 2, **dadurch gekennzeichnet, dass** die Stromschiene (3) durch eine Reflow-Lötverbindung mit Anschlussleiterbahnen der Leiterplatte 1 verbunden ist.

4. Elektrische Leiterplatte (1) nach Anspruch 3, **dadurch gekennzeichnet, dass** seitlich neben der Ausnehmung (5) der Leiterplatte (1) durch Teile der Anschlussleiterbahnen der Leiterplatte (1) gebildete, großflächige Lötpads (7) angeordnet sind.

5. Elektrische Leiterplatte (1) nach einem der Ansprüche 1 bis 4, **dadurch gekennzeichnet, dass** ein in der Mitte des Blechs im Bereich der oberen Kante (3b) der Stromschiene (3) freigeschnittener Streifen als eine parallel zum Basisbereich (3a) der Stromschiene (3) verlaufende Zunge (8) ausgestellt ist.

6. Elektrische Leiterplatte (1) nach einem der Ansprüche 1 bis 5, **dadurch gekennzeichnet, dass** die Stromschiene (3) mit zwei Aufstellhaken (13) versehen ist.

7. Elektrische Leiterplatte (1) nach Anspruch 6, **dadurch gekennzeichnet, dass**, die Aufstellhaken (13) aus dem von oben auf die vordere Kante des Basisbereichs (3a) zurückgebogenen Ende des Blechs beiderseits der Ausnehmung 3c, durch die der durch die Anschlussklemme (2) zu kontaktierende Leiter (11) eingeführt wird, zum Rand der Leiterplatte (1) weisend ausgestellt sind.

8. Elektrische Leiterplatte (1) nach einem der Ansprüche 1 bis 7, **dadurch gekennzeichnet, dass** die Leiterplatte (1) auf ihrer Oberseite mit einer annähernd vollflächigen Kupferkaschierung (15) versehen ist, wobei lediglich schmale Pfade (16) zur Trennung der verschiedenen Potentiale voneinander von der Kupferkaschierung (15) befreit sind.

9. Anschlussbox für Solarzellenmodule mit einer elektrischen Leiterplatte (1) nach einem der Ansprüche 1 bis 8, **dadurch gekennzeichnet, dass** auf der Leiterplatte (1) als SMD-Bauelemente ausgebildete Bypass-Dioden (14) vorhanden sind.

## Claims

1. Electrical printed circuit board (1) having a screwless connection terminal (2) which consists of a conductor bar (3) that is soldered to connecting conductive traces on the printed circuit board (1) and a clamping spring (4) located on the conductor bar (3), **characterised in that** the printed circuit board (1) is provided at its edge with a cut-out (5) which is bridged on the upper side of the printed circuit board (1) by a base area (3a) of the conductor bar (3) and that the clamping spring (4) comes to rest with one of its spring legs (4a) on the base area (3a) of the conductor bar (3) in such a manner that another spring leg (4b) extends through the cut-out (5) on the lower side of the printed circuit board (1).

2. Electrical printed circuit board (1) in accordance with Claim 1, **characterised in that** the conductor bar (3) is provided with leads (6') which immerse in allocated holes (7') on the printed circuit board (1).

3. Electrical printed circuit board (1) in accordance with Claim 1 or Claim 2, **characterised in that** the conductor bar (3) is connected to the connecting conductive traces on the printed circuit board 1 by way of a reflow solder joint.

4. Electrical printed circuit board (1) in accordance with Claim 3, **characterised in that** solder pads (7) covering a large area and formed by parts of the connecting conductive traces on the printed circuit board (1) are arranged laterally next to the cut-out (5) on the printed circuit board (1).

5. Electrical printed circuit board (1) in accordance with any of Claims 1 to 4, **characterised in that** a strip that is cut free in the middle of the sheet in the region of the upper edge (3b) of the conductor bar (3) is raised outwards as a tab (8) extending parallel to the base area (3a) of the conductor bar (3).

6. Electrical printed circuit board (1) in accordance with any of Claims 1 to 5, **characterised in that** the conductor bar (3) is provided with two positioning hooks (13).

7. Electrical printed circuit board (1) in accordance with Claim 6, **characterised in that** the positioning hooks (13) project outwards towards the edge of the printed circuit board (1) from the end of the sheet which is bent back from the top on the front edge of the base area (3a) on either side of the cut-out 3c through which the conductor (11) to be contacted by the connection terminal (2) is inserted.

8. Electrical printed circuit board (1) in accordance with any of Claims 1 to 7, **characterised in that** the printed circuit board (1) is provided with a copper lamination (15) over practically the entire surface of its upper side, with merely narrow traces (16) being exposed from the copper lamination (15) for the purpose of separating the various potentials from each other.

9. Terminal box for solar cell modules having an electrical printed circuit board (1) in accordance with any of Claims 1 to 8, **characterised in that** bypass diodes (14) designed as SMD components are provided on the printed circuit board (1).

## Revendications

1. Plaque de circuit imprimé (1), avec une borne de raccordement (2), qui comprend une barre omnibus (3), brasée avec des pistes conductrices de raccordement de la plaque de circuit imprimé (1), ainsi qu'un ressort de serrage (4), fixé sur ladite barre omnibus (3), **caractérisée en ce que** la plaque de circuit imprimé (1) est pourvue, sur son bord, d'un évidement (5), qui est recouvert, sur la face supérieure de ladite plaque de circuit imprimé (1), par une zone de base (3a) de ladite barre omnibus (3), et que le ressort de serrage (4) vient porter contre la zone de base (3a) de ladite barre omnibus (3), avec l'une de ses branches (4a), de sorte qu'une autre branche (4b) s'étende à travers l'évidement (5), sur la face inférieure de la plaque de circuit imprimé (1).

2. Plaque de circuit imprimé (1) selon la revendication 1, **caractérisée en ce que** la barre omnibus (3) est pourvue de pattes de raccordement (6'), qui plongent dans des alésages (7'), pratiqués dans la plaque de circuit imprimé (1).

3. Plaque de circuit imprimé (1) selon la revendication 2, **caractérisée en ce que** la barre omnibus (3) est reliée à des pistes conductrices de raccordement de la plaque de circuit imprimé 1, par une liaison par brasage à reflux.

4. Plaque de circuit imprimé (1) selon la revendication 3, **caractérisée en ce que** des pastilles de brasage (7) de grande surface, formées par des parties des pistes conductrices de raccordement de la plaque de circuit imprimé (1), sont agencées latéralement, à côté de l'évidement (5) de la plaque de circuit imprimé (1).

5. Plaque de circuit imprimé (1) selon l'une des revendications 1 à 4, **caractérisée en ce qu'**une bande, dégagée par coupe au centre de la tôle du bord supérieur (3b) de la barre omnibus (3), est façonnée en forme de languette (8), qui s'étend parallèlement à la zone de base (3a) de ladite barre omnibus (3).

6. Plaque de circuit imprimé (1) selon l'une des revendications 1 à 5, **caractérisée en ce que** la barre omnibus (3) est pourvue de deux crochets d'alignement (13).

7. Plaque de circuit imprimé (1) selon la revendication 6, **caractérisée en ce que** les crochets d'alignement (13) sont orientés vers le bord de la plaque de circuit imprimé (1), à partir de l'extrémité de la tôle repliée d'en haut sur la zone de base (3a), des deux côtés de l'évidement 3c, à travers laquelle passe le conducteur (11), qui est destiné à entrer en contact avec la borne de raccordement (2).

8. Plaque de circuit imprimé selon l'une des revendications 1 à 7, **caractérisée en ce que** la plaque de circuit imprimé (1) est pourvue, sur sa face supérieure, d'une lame de cuivre (15), qui couvre sensiblement toute la surface, sachant que seuls les passages (16) étroits, pour séparer les différents potentiels les uns des autres, sont exempts de lame de cuivre (15).

9. Boîte de raccordement pour des modules solaires, avec une plaque de circuit imprimé (1) selon l'une des revendications 1 à 8, **caractérisée en ce que** des diodes by-pass (14), réalisées en tant qu'éléments SMD, sont prévues sur la plaque de circuit imprimé (1).
